# EUROPEAN PATENT SPECIFICATION

(11) **EP 2 571 055 B1**
(45) Date of publication and mention of the grant of the patent: **05.03.2014**
(21) Application number: 11009530.4
(22) Date of filing: 01.12.2011
(51) Int. Cl.: H01L 27/142, H01L 31/042, H01L 31/0725, H01L 31/068, H01L 31/0376, H01L 31/18, H01L 31/076, H01L 31/0368

(54) **Thin film solar cell module**
Dünnschichtsolarzellenmodul
Module de pile solaire en couche mince

(30) Priority: 15.09.2011 KR 20110093029
(43) Date of publication of application: 20.03.2013
(73) Proprietor: LG Electronics Inc., Yeongdeungpo-gu Seoul 150-721 (KR)
(72) Inventor: You, Dongjoo, Seoul 137-724 (KR); Lee, Byungkee, Seoul 137-724 (KR); Lee, Heonmin, Seoul 137-724 (KR); Hwang, Suntae, Seoul 137-724 (KR); Lee, Sungeun, Seoul 137-724 (KR)
(74) Representative: Katérle, Axel

(56) References cited:
- EP-A1- 2 309 540
- WO-A1-2011/030729
- DE-B1- 1 934 824
- US-A1- 2008 121 264
- US-A1- 2008 216 886
- US-A1- 2011 041 901

## Description

### BACKGROUND

### 1. Field

The present disclosure relates to a thin film solar cell module.

### 2. Related Art

Recently, as it is expected that conventional energy resources such as petroleum and coal will be exhausted, interest in alternative energy replacing the conventional energy resources is gradually increasing.

Although single crystal bulk silicon using a silicon wafer is commercially used today, the problem is that manufacturing cost thereof is expensive and thus, the single crystal bulk silicon is not widely used.

In order to solve this problem, research for a thin film solar cell is actively being conducted. Particularly, a thin film solar cell using an amorphous silicon (a-Si:H) is a technology for a large area solar cell module with low cost and thus, is being spotlighted.

Document US 2008/0121264 discloses a thin film solar cell module comprising a plurality of first cells in a central portion and a plurality of second cells in edge regions.

### SUMMARY

Accordingly, one object is to address the above-noted and other drawbacks of the related art.

Another object is to provide a solar cell module including a substrate; a plurality of first cells positioned in a central region, one or more first cells including at least one photovoltaic unit; and a plurality of second cells positioned in edge regions of the substrate, one or more second cells including at least one photovoltaic unit; wherein among the photovoltaic units positioned in the same layer the photovoltaic unit of the one or more second cells has higher band gap energy than that the photovoltaic unit of the one or more first cells. The one or more first cells and the one or more second cells may include a same number of photovoltaic units.

The voltage relative amount {(voltage of second cell)/(voltage of first cell)} and current relative amount {(current of first cell)/(current of second cell)} of the one or more first cells and the one or more second cells are 100% to 120%, preferably, voltage relative amount {(voltage of second cell)/(voltage of first cell)} and current relative amount {(current of first cell)/(current of second cell)} of the one or more first cells and the one or more second cells are 102% to 105%.

Voltage of the one or more second cells is higher than voltage of the one or more first cells and current of the one or more second cells is higher than current of the one or more first cells.

The one or more second cells may be positioned within 4cm from an edge of the substrate.

The photovoltaic unit of the one or more first cells and the photovoltaic unit of the one or more second cells in the same layer comprise one or more intrinsic semiconductor layers containing amorphous silicon germanium (a-SiGe), and the one or more intrinsic semiconductor layers of the one or more first cells contain germanium with higher concentration than that of the one or more intrinsic semiconductor layers of the one or more second cells.

The concentration of germanium contained in the one or more intrinsic semiconductor layers of the one or more first cells is reduced as the one or more first cells are closer to the edge regions and the band gap energy of the one or more intrinsic semiconductor layers of the one or more first cells increases as the one or more first cells are closer to the edge regions.

The photovoltaic unit of the one or more first cells and the photovoltaic unit of the one or more second cells in the same layer comprise one or more intrinsic semiconductor layers containing micro crystalline silicon (µ c-Si). In this case, the one or more intrinsic semiconductor layers of the one or more first cells contain germanium with higher crystallinity than that of the one or more intrinsic semiconductor layers of the one or more second cells and crystallinity of the one or more second cells is lower than crystallinity of the one or more first cells by 7% to 10%.

The thin film solar cell module further includes one or more seed layers coming in contact with the one or more intrinsic semiconductor layers of the one or more first cells; and one or more seed layers coming in contact with the one or more intrinsic semiconductor layers of the one or more second cells and the one or more seed layers of the one or more first cells have higher crystallinity than that of the one or more seed layers of the one or more second cells.

According one aspect, since band gap energy of the photovoltaic units of the plurality of second cells that are positioned in an edge region of the substrate is higher than that the photovoltaic units of the plurality of first cells that are positioned in the central region of the substrate, the voltage of the second cells is increased relatively than that of the first cells and current of the second cells is reduced relatively than that of the first cells.

Therefore, when the band gap energy of the photovoltaic units of the first cells and the second cells is controlled such that voltage relative amount and current relative amount become 100% or more and 120% or less respectively, efficiency of the thin film solar cell increases.

### BRIEF DESCRIPTION OF THE DRAWINGS

The accompanying drawings, which are included to provide a further understanding of the disclosure and are incorporated in and constitute a part of this application, illustrate embodiment(s) of the invention and together with the description serve to explain the principle of the invention. In the drawings:
FIG. 1 is a plan view of a thin film solar cell module.
FIG. 2 is a graph illustrating a current-voltage (I-V) curve.
FIG. 3 is a graph illustrating relationship between a voltage relative amount and efficiency.
FIG. 4 is a graph illustrating relationship between a current relative amount and efficiency.
FIG. 5 is a sectional view illustrating structure of a cell used in the thin film solar cell module of FIG. 1, which shows a cell having a double junction type photovoltaic unit.
FIG. 6 is a sectional view illustrating structure of a cell used in the thin film solar cell module of FIG. 1, which shows a cell having a triple junction type photovoltaic unit.
FIG. 7 is a graph showing relationship between concentration of germanium (Ge) contained in the photovoltaic unit and band gap energy.
FIG. 8 is a graph showing concentration of germanium of the photovoltaic unit according to the position of the substrate.
FIG. 9 is a graph showing band gap energy of the photovoltaic unit according to the position of the substrate.
FIG. 10 is a sectional view illustrating structure of a triple junction type cell used in the thin film solar cell module of FIG. 1, which shows a cell having a seed layer.
FIG. 11 is a sectional view illustrating crystallinity of crystalline silicon according to crystallinity of the seed layer.

### DETAILED DESCRIPTION OF THE PREFERRED EMBODIMENTS

Reference will now be made in detail to the preferred embodiments of the present invention, examples of which are illustrated in the accompanying drawings.

The terminology used herein is for the purpose of describing particular embodiments only and is not intended to be limiting the scope of the invention.

The preferred embodiments of the present invention will be described in detail with reference to accompanying drawings such that those skilled in the art may fully understand the concept of the present invention. However, various changes in form and detail may be made without departing from the scope of the invention. Throughout this specification, like reference numerals may be used to refer to like elements.

Hereinafter, throughout the drawings, in order to illustrate several layers and regions clearly, thickness may be enlarged. When a layer, a film, a region, and a plate are "on" another element, it includes not only a case when the respective elements are "directly" on another element but may include a case when the respective elements are at intermediate portion thereof. On the contrary, a case when a certain element is "directly" on another element means that there is no element at the intermediate portion.

On the contrary, a case when a certain element is "directly" on another element means that there is no element at the intermediate portion. In addition, a case when a certain element is formed on another element entirely may include a case when the element is formed not only on the entire surface (or whole surface) of another element but at some of an edge.

Hereinafter, a thin film solar cell module according to an embodiment of the present invention will be described with reference to the accompanying drawings.

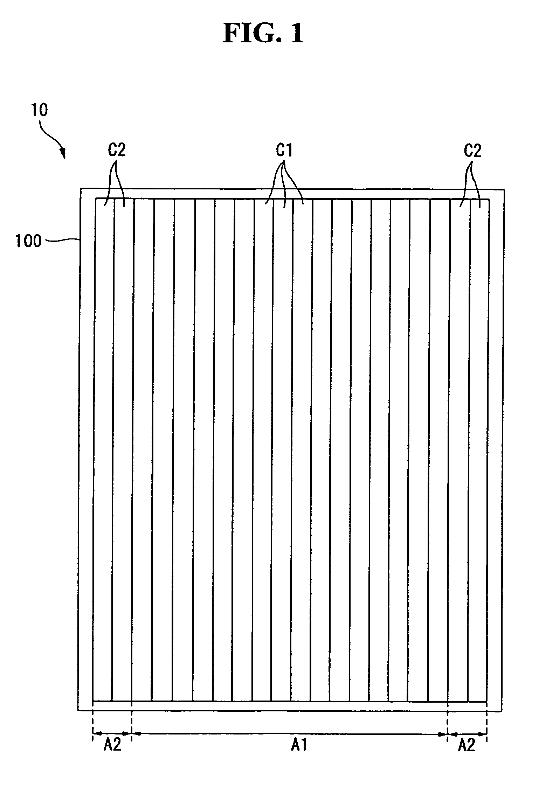

Referring to FIG. 1, a thin film solar cell module 10 includes a substrate 100 and a plurality of thin film solar cells 150 disposed on the substrate 100.

The substrate 100 includes a central region A1 and an edge region A2 positioned at edge of the central region A1 and the plurality of thin film solar cells 200 are positioned in the central region A1 and the edge region A2 respectively.

Hereinafter, to simplify the disclosure, the plurality of thin film solar cells positioned in the central region A1 are referred to as first cells C1 and the plurality of thin film solar cells positioned in the edge region A2 are referred to as second cells C2.

In general, large area solar cells of 1.1*1.3m², 1.1*1.4 m², 2.2*2.6 m² are dealt in markets and thin film solar cells of 1.1*1.3m² and 1.1*1.4 m² may include 100 or more cells.

The intention here is to control characteristics of the first cells C1 and the second cells C2 to improve efficiency of the large area thin film solar cell module. In this disclosure, the second cells C2 may be cells positioned in the edge region A2 within 4cm from the edge of the substrate and the first cells C1 may be cells positioned in the central region A1 between the edge regions A2. Therefore, the first cells C1 may be the rest of the cells excluding the second cells C2.

Hereinabove, although the edge regions A2 are spaced apart from the edge of the substrate by 4cm, the edge regions A2 may be increased as the module increases in size.

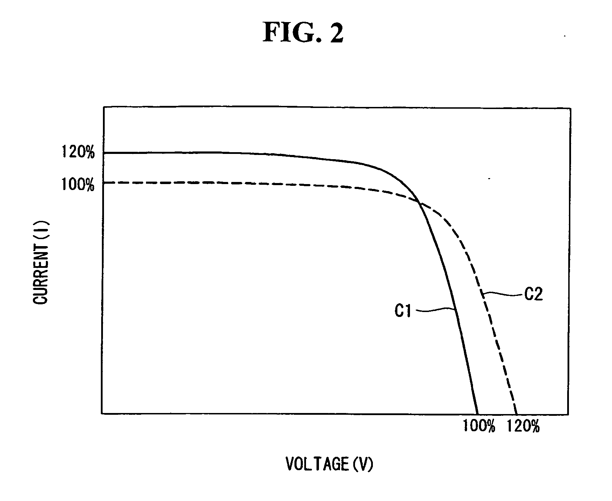

FIG. 2 is a graph illustrating a current-voltage (I-V) curve of the first cells C1 and the second cells C2. In FIG. 2, a solid line indicates a current-voltage curve of the first cells C1 and a dotted line indicates a current-voltage curve of the second cells C2.

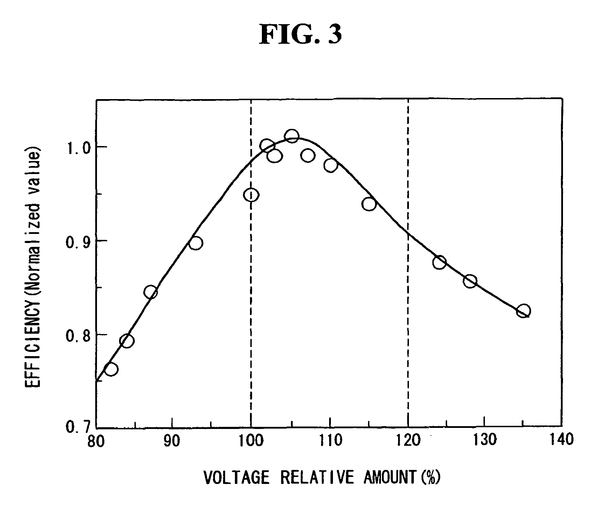

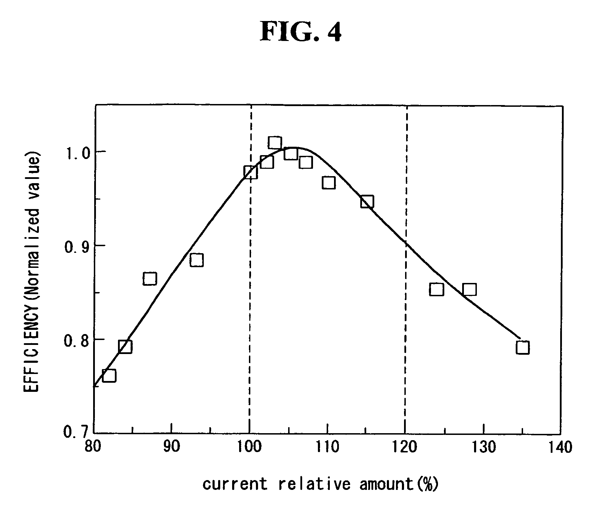

FIG. 3 is a graph illustrating relationship between a voltage relative amount and efficiency. FIG. 4 is a graph illustrating relationship between a current relative amount and efficiency. The voltage relative amount means percentage of {(voltage of second cell)/(voltage of first cell)} and the current relative amount means percentage of {(current of first cell) / ( current of second cell)}.

Referring to FIGS. 3 and 4, when the voltage relative amount and the current relative amount are greater than 100% and less than 120% respectively, efficiency of the thin film solar cell module may increase and that power of the module may be also maximized.

Hereinafter, a thin film solar cell module in which the voltage relative amount and the current relative amount satisfy the above-mentioned range will be described.

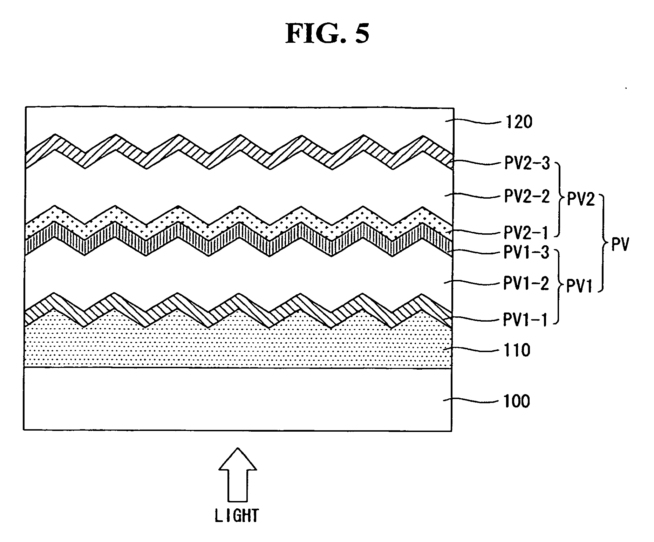

FIG. 5 is a sectional view illustrating structure of a cell used in the thin film solar cell module of FIG. 1, which shows a cell having a double junction type photovoltaic unit.

In this embodiment, since the first cells and the second cells have the same structure, hereinafter only the sectional structure of the first cells will be described.

As illustrated in FIG.. 5, a first cell C1 may include a first electrode 110, a photovoltaic unit PV, and a second electrode 120 that are sequentially formed on the substrate 100.

The first electrode 110 may be made of transparent conductive material such as one selected from a group of consisting of silicon oxide SiO₂, zinc oxide AnO, or indium tin oxide ITO. In addition, the first electrode 110 may be made of mixture in which one or more impurity is mixed with the transparent conductive material.

The photovoltaic unit PV positioned on the first electrode 110 converts light entering an incident surface of the substrate 100 into electricity and may be one of a single junction type structure, a double junction type structure, and triple junction structure. In this embodiment, the double junction type photovoltaic unit will be described.

The photovoltaic unit PV of this embodiment further includes a first photovoltaic unit PV1 positioned on the first electrode 110 and a second photovoltaic unit PV2 positioned between the first photovoltaic unit PV1 and the second electrode 120.

The first photovoltaic unit PV1 includes amorphous silicon a-Si and generally absorbs light of short wavelength band such as near ultraviolet rays, violet rays, and blue rays.

This first photovoltaic unit PV1 includes a first P-type semiconductor layer PV1-1, a first intrinsic semiconductor layer PV1-2, and a first N-type semiconductor layer PV1-3 that are sequentially formed on the first electrode 110.

The first P-type semiconductor layer PV1-1 may be made by mixing gas containing triad impurity such as boron, gallium, and indium with source gas containing silicon Si. In this embodiment, the first P-type semiconductor layer PV1-1 may be made of a-Si or a-Si:H.

The intrinsic semiconductor layer PV1-2 is to reduce recombination of carriers and to absorb light, wherein the carriers such as electrons and holes are generated therefrom. The first intrinsic semiconductor layer PV1-2 may be made of a-Si or a-Si:H and may have a thickness of about 200nm to 300nm.

The first N-type semiconductor layer PV1-3 may be made by mixing gas containing pentads impurity such as phosphorus P, arsenic As, and antimony Sb with source gas containing silicon.

This first photovoltaic unit PV1 may be made by chemical vapor deposition (CVD) such as plasma enhanced chemical vapor deposition (PECVD).

The semiconductor layers such as the first P-type semiconductor layer PV1-1 and the first N-type semiconductor layer PV1-3 of the first photovoltaic unit PV1 form a P-N junction interposing the first intrinsic semiconductor layer PV1-2 therebetween. Electrons and holes are generated from the first intrinsic semiconductor layer PV1-2 due to photovoltaic effect caused by the P-N junction which separates the electrons and the holes from each other by contact voltage difference and causes the electrons and the holes to migrate in different directions.

For example, the holes migrate toward the first electrode 110 through the first P-type semiconductor layer PV1-1 and the electrons migrate toward the second electrode 120 through the first N-type semiconductor layer PV1-3.

The second photovoltaic unit PV2 may include micro crystalline silicon µ c-Si and generally may absorb light of long wavelength band from red to near infrared rays.

The second photovoltaic unit PV2 may include a second P-type semiconductor layer PV2-1, a second intrinsic semiconductor layer PV2-2, and a second N-type semiconductor layer PV2-3 that are sequentially formed on the first N-type semiconductor layer PV1-3 of the first photovoltaic unit PV1. This may be made by CVD such as PECVD like the case of the first photovoltaic unit PV1.

The second P-type semiconductor layer PV2-1 may be made by mixing gas containing triad impurity such as boron, gallium, and indium with source gas containing silicon.

The second intrinsic semiconductor layer PV2-2 is to reduce recombination of carriers and to absorb light. Due to this, the second intrinsic semiconductor layer PV2-2 generally absorbs applied light of long wavelength band and generates electrons and holes.

In this embodiment, the second intrinsic semiconductor layer PV2-2 may be made of micro crystalline silicon µ c-Si or doped micro crystalline silicon µ c-Si:H and may be thicker than the first intrinsic semiconductor layer PV1-2 in order to sufficiently absorb solar light of long wavelength.

The second N-type semiconductor layer PV2-3 may be made by mixing gas containing pentads impurity such as phosphorus P, arsenic As, and antimony Sb with source gas containing silicon.

The second P-type semiconductor layer PV2-1 and the second N-type semiconductor layer PV2-3 of the second photovoltaic unit PV2 form P-N junction interposing the second intrinsic semiconductor layer PV2-2 therebetween, and electrons and holes are generated from the second intrinsic semiconductor layer PV2-2 due to photovoltaic effect caused by the P-N junction. The holes migrate toward the first electrode 110 to be collected and the electrons migrate toward the second electrode 120 through the second N-type semiconductor layer PV2-3 to be collected.

The second electrode 120 positioned on the photovoltaic unit PV may be made of one selected from a group including gold Au, silver Ag, and aluminum A1 and may further include a reflecting layer for reflecting light unabsorbed by the photovoltaic unit PV toward the photovoltaic unit PV.

In the thin film solar cell module having the above-described cells, voltage relative amount {(voltage of second cell)/(voltage of first cell)} and current relative amount {(current of first cell)/(current of second cell)} of the first cell and the second cell satisfy 100% to 120% respectively, preferably, the voltage relative amount {(voltage of second cell)/(voltage of first cell)} and the current relative amount {(current of first cell)/(current of second cell)} of the first cell and the second cell satisfy 102% to 105% respectively.

In order for the voltage relative amount and the current relative amount to satisfy the above-mentioned ranges, in this embodiment, band gap energy of the second intrinsic semiconductor layer PV2-2 of the first cell C1 and the second intrinsic semiconductor layer PV2-2 of the second cell C2 have different amount.

In more detail, the band gap energy of the second intrinsic semiconductor layer PV2-2 of the second cell C2 is greater than band gap energy of the second intrinsic semiconductor layer PV2-2 of the first cell C1. Therefore, voltage of the second cell C2 is higher than voltage of the first cell C1 and current of the first cell C1 is higher than current of the second cell C2.

Here, in order to make the band gap energy of the second intrinsic semiconductor layer PV2-2 of the second cell C2 higher than the band gap energy of the second intrinsic semiconductor layer PV2-2 of the first cell C1, crystallinity of the second intrinsic semiconductor layer PV2-2 of the first cell C1 is higher than crystallinity of the second intrinsic semiconductor layer PV2-2 of the second cell C2.

The crystallinity of the second intrinsic semiconductor layer PV2-2 is measured using Raman and following Table 1 lists voltage relative amount, current relative amount, and efficiency according to crystallinity of the second intrinsic semiconductor layer PV2-2.

**Table 1**

| Crystallinity of 2^{nd} intrinsic semiconductor layer | | Voltage relative amount(voltage of C2/voltage of C1) | Current relative amount(current of C1/current of C2) | Efficiency |
|---|---|---|---|---|
| C2 | C1 | | | |
| 71% | 60% | 83% | 82% | 78% |
| 71% | 70% | 99% | 98% | 90% |
| 68% | 69% | 100% | 102% | 93% |
| 60% | 68% | 102% | 103% | 100% |
| 56% | 66% | 104% | 105% | 99% |
| 50% | 65% | 107% | 109% | 95% |
| 58% | 50% | 126% | 128% | 84% |

Referring to Table 1, efficiency is remarkably reduced when the voltage relative amount and the current relative amount are less than 100% and exceed 120% respectively. Efficiency is excellent when the voltage relative amount and the current relative amount are greater than 100% and less than 120% respectively.

Particularly, the efficiency is the best when the voltage relative amount and the current relative amount are greater than 103% and less than 105%. Referring to Table. 1, crystallinity of the second intrinsic semiconductor layer PV2-2 of the second cell C2 is lower than crystallinity of the second intrinsic semiconductor layer PV2-2 of the first cell C1 by 7% to 10% when the voltage relative amount and the current relative amount is greater than 103% and less than 105%. Therefore, it is preferred that crystallinity of the second intrinsic semiconductor layer PV2-2 of the second cell C2 is lower than crystallinity of the second intrinsic semiconductor layer PV2-2 of the first cell C1 by 7% to 10%.

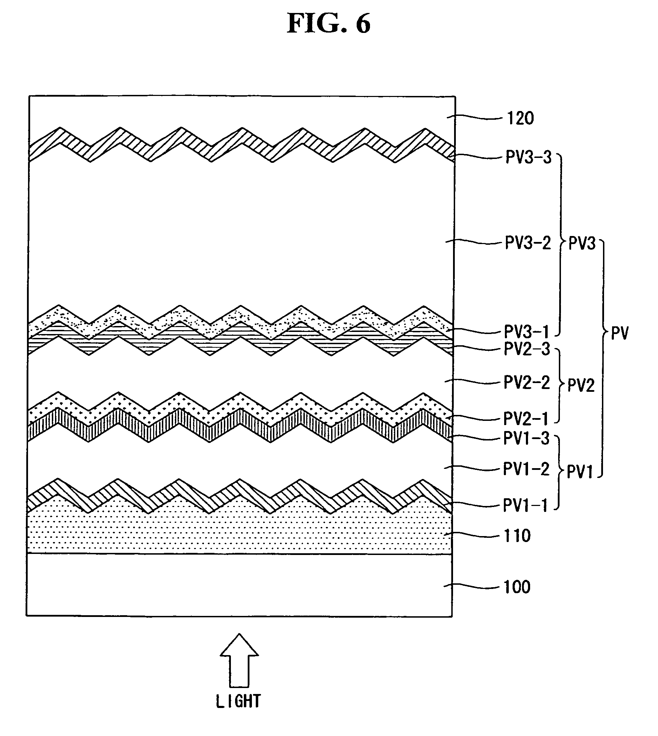

FIG. 6 is a sectional view illustrating structure of a cell used in the thin film solar cell module of FIG. 1, which shows a cell having a triple junction type photoelectric converting unit.

In a cell having the triple junction type photovoltaic unit, the first photovoltaic unit may include amorphous silicon, the second photovoltaic unit may include amorphous silicon germanium a-SiGe or microcrystal silicon µ c-Si, and a third photovoltaic unit may include microcrystal silicon µ c-Si or microcrystal silicon germanium µ a-SiGe.

In this embodiment, a case where the first photovoltaic unit PV1 includes amorphous silicon and the second photovoltaic unit PV2 includes amorphous silicon germanium, and the third photovoltaic unit PV3 includes microcrystal silicon will be described.

Since the first to second photovoltaic units PV1, and PV2 have P-I-N structure like the embodiment illustrated in FIG. 5, hereinafter only the third photovoltaic unit PV3 will be described.

The third photovoltaic unit PV3 may include a third P-type semiconductor layer PV3-1, a third intrinsic semiconductor layer PV3-2, and a third N-type semiconductor layer PV3-3.

Since light that is not absorbed by the first photovoltaic unit PV1 and the second photovoltaic unit PV2 enters the triple junction type photovoltaic unit PV3, a small amount of light enters the third intrinsic semiconductor layer PV3-2. Therefore, sufficient light absorption is achieved when the third intrinsic semiconductor layer PV3-2 is thicker than the second intrinsic semiconductor layer PV2-2. Therefore, in this embodiment, the third intrinsic semiconductor layer PV3-2 may be made with thickness of 2µm to 3µm. For reference, in the embodiment illustrated in FIG. 5, the second intrinsic semiconductor layer PV2-2 may have a thickness of 1.5 µm.

Although not illustrated, an intermediate reflecting layer may be disposed between the second photovoltaic unit PV2 and the third photovoltaic unit PV3.

In the cell having this structure, in order to adjust the voltage relative amount and the current relative amount by controlling voltage and current of the first cell C1 and the second cell C2, crystallinity of the third intrinsic semiconductor layer PV3-2 of the first cell C1 and the third intrinsic semiconductor layer PV3-2 of the second cell C2 is adjusted in a method similar to that in the embodiment illustrated in FIG. 5. Voltage relative amount, current relative amount, and efficiency according to the crystallinity of the third intrinsic semiconductor layer PV3-2 are listed in following Table 2.

Referring to Table 2, Table 2 is similar to Table 1 indicating the result of the embodiment illustrated in FIG. 5.

That is, efficiency is remarkably reduced when voltage relative amount and current relative amount are less than 100% and exceed 120%, but excellent when voltage relative amount and current relative amount are greater than 100% and less than 120%.

In addition, efficiency is the best when voltage relative amount and current relative amount are greater than 102% and less than 105%. To this end, it is preferred that crystallinity of the second intrinsic semiconductor layer PV2-2 of the second cell C2 is lower than crystallinity of the second intrinsic semiconductor layer PV2-2 of the first cell C1 by 7% to 10%.

**Table 2**

| Crystallinity of 3^{rd} intrinsic semiconductor layer | | Voltage relative amount(voltage of C2/voltage of C1) | Current relative amount(current of C1/current of C2) | Efficiency |
|---|---|---|---|---|
| C2 | C1 | | | |
| 60% | 40% | 80% | 75% | 76% |
| 73% | 61% | 85% | 80% | 79% |
| 69% | 68% | 99% | 97% | 91% |
| 68% | 68% | 100% | 102% | 93% |
| 60% | 67% | 102% | 102% | 100% |
| 59% | 65% | 103% | 104% | 99% |
| 50% | 65% | 107% | 109% | 95% |
| 40% | 75% | 112% | 115% | 91% |
| 10% | 50% | 125% | 127% | 85% |

Hereinabove, although a case where crystallinity of the third intrinsic semiconductor layer PV3-2 of the third photovoltaic unit PV3 is different from those of the first cell C1 and the second cell C2 has been described, it is possible that band gap energy of the second intrinsic semiconductor layer PV2-2 of the first cell C1 and the second intrinsic semiconductor layer PV2-2 of the second cell C2 may be controlled by adjusting concentration of germanium Ge contained in the second intrinsic semiconductor layer PV2-2 so as to adjust the voltage relative amount and the current relative amount.

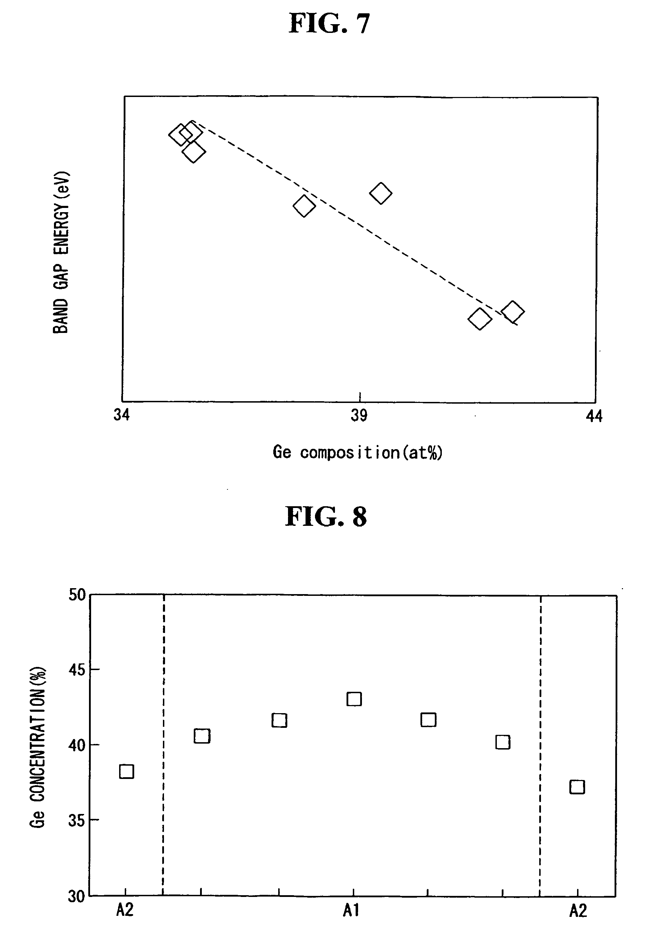

FIG. 7 is a graph showing relationship between concentration of germanium Ge contained in the photovoltaic unit and band gap energy. Referring to FIG. 7, it is understood that it is possible to control band gap energy according to concentration of germanium contained in the second intrinsic semiconductor layer PV2-2.

Therefore, when the second intrinsic semiconductor layer PV2-2 is deposited using PECVD, it is possible to make concentration of germanium of the second intrinsic semiconductor layer PV2-2 different according to position of a substrate as illustrated in FIG. 8 by varying processing factors such as a gap between electrodes, flow rate of processing gas containing H₂, SiH₄, and GeH₄, and gas ratio GeH₄/SiH₄ .

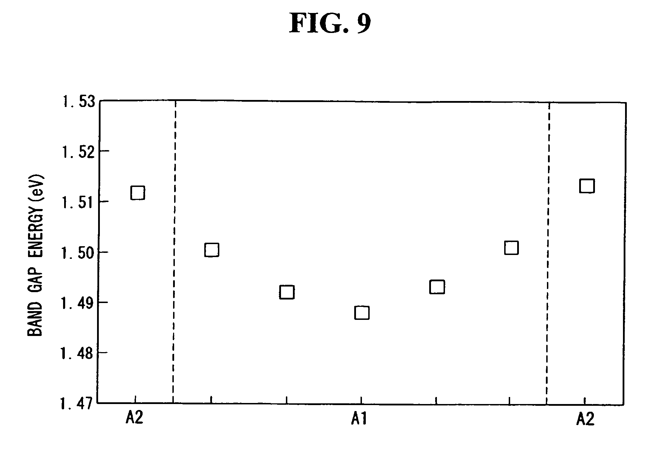

When concentration of germanium of the second intrinsic semiconductor layer PV2-2 is set as the graph of FIG. 8, the second intrinsic semiconductor layer PV2-2, as illustrated in FIG. 9, has different quantity of band gap energy according to the position of a substrate.

FIG. 9 is a graph showing band gap energy of the second intrinsic semiconductor layer PV2-2 measured according to the position of the substrate by an ellipsometer. As shown in FIG. 9, the band gap of the second cell C2 is greater than the band gap of the first cell C1.

Concentration of germanium contained in the second intrinsic semiconductor layer PV2-2 may be adjusted according to the position of a substrate, as illustrated in FIG. 9, such that band gap energy of the respective second intrinsic semiconductor layers PV2-2 of the first cells C1 increase as close to the second cells C2 positioned in the edge region.

As such, when the second intrinsic semiconductor layer PV2-2 of the first cell C1 has higher concentration of germanium than that of the second intrinsic semiconductor layer PV2-2 of the second cell C2, the second cell C2 has higher band gap energy than that of the first cell C1.

The following Table 3 lists voltage relative amount, current relative amount, and efficiency according to the band gap energy of the second intrinsic semiconductor layer PV2-2. Referring to Table 3, when the first cell C1 has lower band gap energy than the second cell C2, the voltage relative amount and the current relative amount higher than 100% may be achieved, and due to this, relatively high efficiency may be obtained.

**Table 3**

| Band gap energy of 2^{nd} intrinsic semiconductor layer | | Voltage relative amount(voltage of C2/voltage of C1) | Current relative amount(current of C1/current of C2) | Efficiency |
|---|---|---|---|---|
| C2 | C1 | | | |
| 1.46eV | 1.50eV | 95% | 94% | 91% |
| 1.48eV | 1.48eV | 97% | 98% | 97% |
| 1.50eV | 1.47eV | 102% | 102% | 100% |

Therefore, when concentration of germanium of the second intrinsic semiconductor layer PV2-2 is adjusted, the voltage relative amount and the current relative amount of the first cell C1 and the second cell C2 may be greater than 100% and less than 120%.

Hereinabove, although the adjustment of concentration of germanium of the second photovoltaic unit PV2 containing amorphous silicon germanium has been described, it is also possible to adjust band gap energy of the second photovoltaic unit PV2 and the third photovoltaic unit PV3 together.

In this case, crystallinity of the third photovoltaic unit PV3 containing micro crystalline silicon may be also adjusted while concentration of germanium of the second photovoltaic unit PV2 containing amorphous silicon germanium.

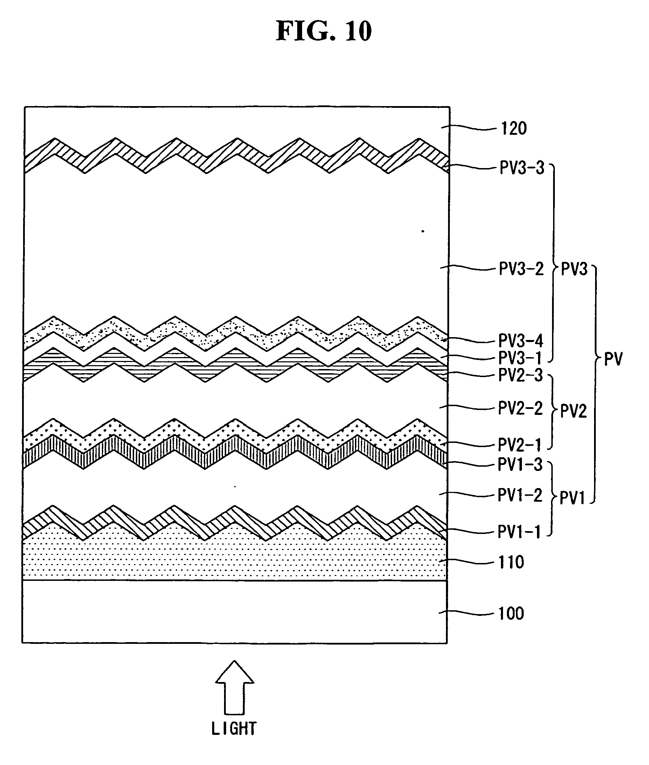

FIG. 10 is a sectional view illustrating structure of a triple junction type cell used in the thin film solar cell module of FIG. 1, and shows a cell having a seed layer.

Difference between this embodiment and the triple junction type cell is that a seed layer PV3-4 made of micro crystals is formed between the third P-type semiconductor layer PV3-1 containing micro crystalline silicon and the third intrinsic semiconductor layer PV3-2. Other elements may be the same as those of the previous embodiments.

In following embodiment, a triple junction type cell will be illustrated, however, the seed layer PV3-4 may be formed between the second P-type semiconductor layer PV2-1 and the second intrinsic semiconductor layer PV2-2 in the double junction type cell as illustrated in FIG. 5.

The seed layer PV3-4 has sufficient crystallinity at the early deposition and assists growth of crystals of the subsequently deposited third intrinsic semiconductor layer PV3-2.

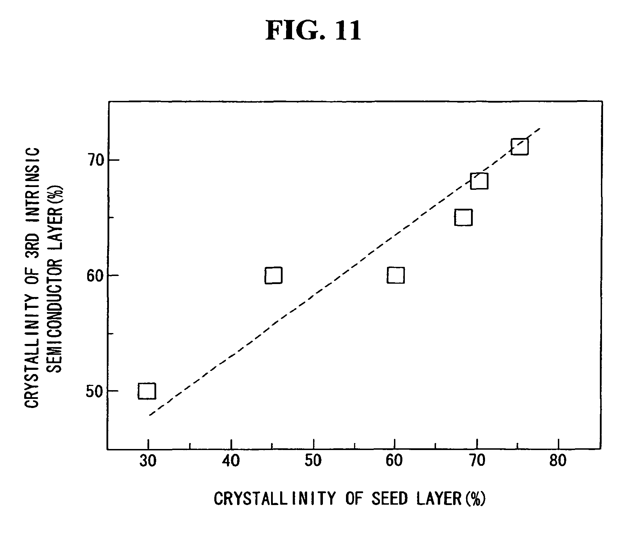

Therefore, as illustrated in FIG. 11, the higher crystallinity of the seed layer PV3-4 is higher than the higher crystallinity of the subsequently deposited third intrinsic semiconductor layer PV3-2. The lower crystallinity of the seed layer PV3-4 is lower than the lower crystallinity of the subsequently deposited third intrinsic semiconductor layer PV3-2.

Crystallinity of the seed layer PV3-4 is linearly proportional to crystallinity of the third intrinsic semiconductor layer PV3-2.

Using this, in this embodiment, crystallinity of the seed layer PV3-4 is adjusted according to the position of a substrate.

**Table 4**

| Crystallinity of seed layer | | Crystallinity of 3^{rd} intrinsic semiconductor layer | |
|---|---|---|---|
| C2 | C1 | C2 | C1 |
| 75% | 45% | 71% | 60% |
| 60% | 70% | 60% | 68% |
| 30% | 68% | 50% | 65% |

Table 4 lists result of adjusting crystallinity of the seed layer PV3-4 according to the position of a substrate to adjust crystallinity of the third intrinsic semiconductor layer PV3-2.

Crystallinity of the seed layer PV3-4 according to the position of a substrate may be adjusted by controlling processing factors such as gap between electrodes, pressure, gas flow rate, and gas ratio.

As such, crystallinity of the third intrinsic semiconductor layer PV3-2 is adjusted by adjusting crystallinity of the seed layer PV3-4 so that voltage relative amount and current relative amount of the first cells and the second cells may be 100% to 120% respectively.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A thin film solar cell module (10) comprising:
a substrate (100);
a plurality of first cells (C1) positioned in a central region, one or more first cells including at least one photovoltaic unit (PV); and
a plurality of second cells positioned (C2) in edge regions of the substrate, one or more second cells including at least one photovoltaic unit (PV);
**characterised in that** among the photovoltaic units (PV) positioned in a same layer the photovoltaic unit of the one or more second cells has a higher band gap energy than that the photovoltaic unit of the one or more first cells.

2. The thin film solar cell module of claim 1, wherein the one or more first cells and the one or more second cells include a same number of photovoltaic units.

3. The thin film solar cell module of claim 1 or 2, wherein a relative voltage amount, that is the ratio between the voltage of the second cell and the voltage of the first cell under open- circuit conditions and a relative current amount, that is the ratio between the current of the first cell and the current of the second cell under short-circuit conditions of the one or more first cells and the one or more second cells are 100% to 120%.

4. The thin film solar cell module of claim 1 or 2, wherein a relative voltage amount, that is the ratio between the voltage of the second cell and the voltage of the first cell under open- circuit conditions and a relative current amount, that is the ratio between the current of the first cell and the current of the second cell under short-circuit conditions of the one or more first cells and the one or more second cells are 102% to 105%.

5. The thin film solar cell module of any one preceding claim, wherein in photovoltaic units positioned in the same layer, a voltage of the one or more second cells is higher than a voltage of the one or more first cells, and a current of the one or more first cells is higher than a current of the one or more second cells.

6. The thin film solar cell module of any one preceding claim, wherein the photovoltaic unit of the one or more first cells and the photovoltaic unit of the one or more second cells in the same layer comprise one or more intrinsic semiconductor layers containing amorphous silicon germanium (a-SiGe), and the one or more intrinsic semiconductor layers of the one or more first cells contain germanium with a higher concentration than that of the one or more intrinsic semiconductor layers of one or more the second cells.

7. The thin film solar cell module of claim 6, wherein the concentration of germanium contained in the one or more intrinsic semiconductor layers of the one or more first cells is reduced as the one or more first cells are closer to the edge regions.

8. The thin film solar cell module of claim 6 or 7, wherein the band gap energy of the one or more intrinsic semiconductor layers of the one or more first cells increases as the one or more first cells are closer to the edge regions.

9. The thin film solar cell module of any one preceding claim, wherein the photovoltaic unit of the one or more first cells and the photovoltaic unit of the one or more second cells in the same layer comprise one or more intrinsic semiconductor layers containing micro crystalline silicon (µc-Si),
the one or more intrinsic semiconductor layers of the one or more first cells contain germanium with a higher crystallinity than that of the one or more intrinsic semiconductor layers of the one or more second cells.

10. The thin film solar cell module of claim 9, wherein crystallinity of the one or more second cells is lower than crystallinity of the one ore more first cells by 7% to 10%.

11. The thin film solar cell module of claim 9 or 10, further comprising:
one or more seed layers coming in contact with one or more the intrinsic semiconductor layers of the one or more first cells; and
one or more seed layers coming in contact with the one or more intrinsic semiconductor layers of the one or more second cells,
wherein the one or more seed layers of the one or more first cells have a higher crystallinity than that of the one or more seed layers of the one or more second cells.

## Patentansprüche

1. Dünnfilm-Solarzellenmodul (10) umfassend:
ein Substrat (100),
eine Mehrzahl in einem Zentralbereich angeordneter erster Zellen (C1), wobei eine oder mehrere erste Zellen mindestens eine Photovoltaikeinheit (PV) umfassen, und
eine Mehrzahl in Randbereichen des Substrats angeordneter zweiter Zellen (C2), wobei eine oder mehrere zweite Zellen mindestens eine Photovoltaikeinheit (PV) umfassen,
**dadurch gekennzeichnet, dass** unter den in derselben Schicht angeordneten Photovoltaikeinheiten (PV) die Photovoltaikeinheit der einen oder mehreren zweiten Zellen eine größere Bandlückenenergie besitzt als die Photovoltaikeinheit der einen oder mehreren ersten Zellen.

2. Dünnfilm-Solarzellenmodul nach Anspruch 1, wobei die eine oder mehreren ersten Zellen und die eine oder mehreren zweiten Zellen eine gleiche Anzahl Photovoltaikeinheiten umfassen.

3. Dünnfilm-Solarzellenmodul nach Anspruch 1 oder 2, wobei eine relative Spannungsmenge, nämlich das Verhältnis zwischen der Spannung der zweiten Zelle und der Spannung der ersten Zelle, unter Leerlaufbedingungen und eine relative Strommenge, nämlich das Verhältnis zwischen dem Strom der ersten Zelle und dem Strom der zweiten Zelle, unter Kurzschlussbedingungen der einen oder mehreren ersten Zellen und der einen oder mehreren zweiten Zellen 100% bis 120% betragen.

4. Dünnfilm-Solarzellenmodul nach Anspruch 1 oder 2, wobei eine relative Spannungsmenge, nämlich das Verhältnis zwischen der Spannung der zweiten Zelle und der Spannung der ersten Zelle, unter Leerlaufbedingungen und eine relative Strommenge, nämlich das Verhältnis zwischen dem Strom der ersten Zelle und dem Strom der zweiten Zelle, unter Kurzschlussbedingungen der einen oder mehreren ersten Zellen und der einen oder mehreren zweiten Zellen 102% bis 105% betragen.

5. Dünnfilm-Solarzellenmodul nach einem der vorhergehenden Ansprüche, wobei bei Photovoltaikeinheiten, die in derselben Schicht angeordnet sind, eine Spannung der einen oder mehreren zweiten Zellen größer ist als eine Spannung der einen oder mehreren ersten Zellen und ein Strom der einen oder mehreren ersten Zellen größer ist als ein Strom der einen oder mehreren zweiten Zellen.

6. Dünnfilm-Solarzellenmodul nach einem der vorhergehenden Ansprüche, wobei die Photovoltaikeinheit der einen oder mehreren ersten Zellen und die Photovoltaikeinheit der einen oder mehreren zweiten Zellen in derselben Schicht eine oder mehrere intrinsische Halbleiterschichten umfassen, welche amorphes Silizium-Germanium (a-SiGe) enthält, und wobei die eine oder mehreren intrinsischen Halbleiterschichten der einen oder mehreren ersten Zellen Germanium mit einer größeren Konzentration als diejenige der einen oder mehreren intrinsischen Halbleiterschichten der einen oder mehreren zweiten Zellen enthalten.

7. Dünnfilm-Solarzellenmodul nach Anspruch 6, wobei die Konzentration des Germaniums, das in der einen oder den mehreren intrinsischen Halbleiterschichten der einen oder mehreren ersten Zellen enthalten ist, sinkt, je näher die eine oder mehreren ersten Zellen bei den Randbereichen liegen.

8. Dünnfilm-Solarzellenmodul nach Anspruch 6 oder 7, wobei die Bandlückenenergie der einen oder mehreren intrinsischen Halbleiterschichten der einen oder mehreren ersten Zellen ansteigt, je näher die eine oder mehreren ersten Zellen bei den Randbereichen liegen.

9. Dünnfilm-Solarzellenmodul nach einem der vorhergehenden Ansprüche, wobei die Photovoltaikeinheit der einen oder mehreren ersten Zellen und die Photovoltaikeinheit der einen oder mehreren zweiten Zellen in derselben Schicht eine oder mehrere intrinsische Halbleiterschichten umfassen, welche mikrokristallines Silizium (µc-Si) enthalten, wobei die eine oder mehreren intrinsischen Halbleiterschichten der einen oder mehreren ersten Zellen Germanium mit einer größeren Kristallinität als diejenige der einen oder mehreren intrinsischen Halbleiterschichten der einen oder mehreren zweiten Zellen enthalten.

10. Dünnfilm-Solarzellenmodul nach Anspruch 9, wobei die Kristallinität der einen oder mehreren zweiten Zellen kleiner ist als die Kristallinität der einen oder mehreren ersten Zellen, und zwar um 7% bis 10%.

11. Dünnfilm-Solarzellenmodul nach Anspruch 9 oder 10, ferner umfassend:
eine oder mehrere Keimschichten in Kontakt mit einer oder mehreren der intrinsischen Halbleiterschichten der einen oder mehreren ersten Zellen, und
eine oder mehrere Keimschichten in Kontakt mit der einen oder den mehreren intrinsischen Halbleiterschichten der einen oder mehreren zweiten Zellen,
wobei die eine oder mehreren Keimschichten der einen oder mehreren ersten Zellen eine größere Kristallinität als diejenige der einen oder mehreren Keimschichten der einen oder mehreren zweiten Zellen besitzen.

## Revendications

1. Module (10) de cellules solaires en couches minces comprenant :
un substrat (100) ;
une pluralité de premières cellules (C1) positionnées dans une région centrale, une ou plusieurs premières cellules incluant au moins une unité photovoltaïque (PV) ; et
une pluralité de deuxièmes cellules (C2) positionnées dans des régions de bords du substrat, une ou plusieurs deuxièmes cellules incluant au moins une unité photovoltaïque (PV) ;
**caractérisé en ce que**, parmi les unités photovoltaïques (PV) positionnées dans une même couche, l'unité photovoltaïque de la ou des deuxièmes cellules a une énergie de bande interdite supérieure à celle de l'unité photovoltaïque de la ou des premières cellules.

2. Module de cellules solaires en couches minces selon la revendication 1, dans lequel la ou les premières cellules et la ou les deuxièmes cellules incluent un même nombre d'unités photovoltaïques.

3. Module de cellules solaires en couches minces selon la revendication 1 ou 2, dans lequel une quantité de tension relative, à savoir le rapport entre la tension de la deuxième cellule et la tension de la première cellule sous des conditions de circuit ouvert et une quantité de courant relative, à savoir le rapport entre le courant de la première cellule et le courant de la deuxième cellule sous des conditions de court-circuit de la ou des premières cellules et de la ou des deuxièmes cellules sont 100 % à 120 %.

4. Module de cellules solaires en couches minces selon la revendication 1 ou 2, dans lequel une quantité de tension relative, à savoir le rapport entre la tension de la deuxième cellule et la tension de la première cellule sous des conditions de circuit ouvert et une quantité de courant relative, à savoir le rapport entre le courant de la première cellule et le courant de la deuxième cellule sous des conditions de court-circuit de la ou des premières cellules et de la ou des deuxièmes cellules sont 102 % à 105 %.

5. Module de cellules solaires en couches minces selon une quelconque revendication précédente, dans lequel, dans des unités photovoltaïques positionnées dans la même couche, une tension de la ou des deuxièmes cellules est supérieure à une tension de la ou des premières cellules, et un courant de la ou des premières cellules est supérieur à un courant de la ou des deuxièmes cellules.

6. Module de cellules solaires en couches minces selon une quelconque revendication précédente, dans lequel l'unité photovoltaïque de la ou des premières cellules et l'unité photovoltaïque de la ou des deuxièmes cellules dans la même couche comprennent un ou plusieurs couches intrinsèques de semi-conducteur contenant du silicium-germanium amorphe (a-SiGe), et la ou les couches intrinsèques de semi-conducteur de la ou des premières cellules contient/contiennent du germanium à une concentration supérieure à celle de la ou des couches intrinsèques de semi-conducteur de la ou des deuxièmes cellules.

7. Module de cellules solaires en couches minces selon la revendication 6, dans lequel la concentration de germanium contenue dans la ou les couches intrinsèques de semi-conducteur de la ou des premières cellules est réduite lorsque la ou les premières cellules sont plus proches des régions de bords.

8. Module de cellules solaires en couches minces selon la revendication 6 ou 7, dans lequel l'énergie de bande interdite de la ou des couches intrinsèques de semi-conducteur de la ou des premières cellules augmente lorsque la ou les premières cellules sont plus proches des régions de bords.

9. Module de cellules solaires en couches minces selon une quelconque revendication précédente, dans lequel l'unité photovoltaïque de la ou des premières cellules et l'unité photovoltaïque de la ou des deuxièmes cellules dans la même couche comprennent une ou plusieurs couches intrinsèques de semi-conducteur contenant du silicium monocristallin (µc-Si), la ou les couches intrinsèques de semi-conducteur de la ou des premières cellules contient/contiennent du germanium avec une cristallinité supérieure à celle de la ou des couches intrinsèques de semi-conducteur de la ou des deuxièmes cellules.

10. Module de cellules solaires en couches minces selon la revendication 9, dans lequel la cristallinité de la ou des deuxièmes cellules est inférieure à la cristallinité de la ou des premières cellules de 7 % à 10 %.

11. Module de cellules solaires en couches minces selon la revendication 9 ou 10, comprenant en outre :
une ou plusieurs couches d'ensemencement venant au contact de l'une ou des couches intrinsèques de semi-conducteur de la ou des premières cellules ; et
une ou plusieurs couches d'ensemencement venant au contact de l'une ou des couches intrinsèques de semi-conducteur de la ou des deuxièmes cellules,
dans lequel la ou les couches d'ensemencement de la ou des premières cellules a/ont une cristallinité supérieure à celle de la ou des couches d'ensemencement de la ou des deuxièmes cellules.
